(19) Europäisches Patentamt
European Patent Office
Office européen des brevets

(11) **EP 4 040 187 A1**

(12) **EUROPEAN PATENT APPLICATION**

(43) Date of publication:
**10.08.2022 Bulletin 2022/32**

(21) Application number: **21193869.1**

(22) Date of filing: **30.08.2021**

(51) International Patent Classification (IPC):
**G01S 7/4863** (2020.01)     **G01S 7/4914** (2020.01)
**H01L 31/02** (2006.01)

(52) Cooperative Patent Classification (CPC):
**G01S 7/4863; G01S 7/4816; G01S 7/4868;
G01S 17/10; G01S 17/42; H01L 31/02027;**
G01S 17/931

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **08.02.2021 JP 2021018290**

(71) Applicant: **Kabushiki Kaisha Toshiba
Minato-ku
Tokyo (JP)**

(72) Inventors:
• **TA, Tuan Thanh
Tokyo (JP)**
• **SAI, Akihide
Tokyo (JP)**
• **SUGIMOTO, Toshiki
Tokyo (JP)**

(74) Representative: **Henkel & Partner mbB
Patentanwaltskanzlei, Rechtsanwaltskanzlei
Maximiliansplatz 21
80333 München (DE)**

(54) **LIGHT DETECTION DEVICE AND ELECTRONIC DEVICE**

(57)     A light detection device includes a light receiving element that photoelectrically converts incident light, and a plurality of transistors that controls a bias voltage applied to the light receiving element and controlling reading of an output signal of the light receiving element, wherein the plurality of transistors comprise at least one or more transistors having a first withstand voltage and one or more transistors having a second withstand voltage higher than the first withstand voltage.

1: LIGHT DETECTION DEVICE

FIG. 3

EP 4 040 187 A1

**Description**

FIELD

An example of the present invention relates to a light detection device and an electronic device.

BACKGROUND

Light detection devices such as light receiving elements are widely used in automatic driving technologies and the like. In the automatic driving technology, reflected light from an object is received by a light detection device, and a distance image is generated by measuring a distance to the object. In order to increase the resolution of the distance image, it is necessary to increase the number of light receiving elements per unit area in the light detection device. However, when the size of the light receiving element is reduced, the amount of received light is also reduced, so that the output signal level of the light receiving element is reduced, and it is difficult to distinguish from noise.

Therefore, it is necessary to increase the sensitivity of the light receiving element and to amplify the output signal of the light receiving element. A circuit for improving the sensitivity of a light receiving element and amplifying an output signal is required for each light receiving element, but there remain problems to be studied such as reliability of a transistor constituting the circuit, power consumption, and a circuit area.

BRIEF DESCRIPTION OF THE DRAWINGS

FIG. 1 is a block diagram illustrating a schematic configuration of an electronic device including a light detection device according to the present example;
FIG. 2A is a diagram illustrating a voltage applied to a SPAD;
FIG. 2B is a diagram illustrating a relationship between a reverse bias voltage and sensitivity of the SPAD;
FIG. 3 is a block diagram of a light detection device according to a first example;
FIG. 4A is a circuit diagram illustrating a first specific example of a bias control circuit;
FIG. 4B is a circuit diagram illustrating a second specific example of the bias control circuit;
FIG. 4C is a circuit diagram illustrating a third specific example of the bias control circuit;
FIG. 5A is a circuit diagram of a first example of a buffer amplifier;
FIG. 5B is a circuit diagram of a second example of the buffer amplifier;
FIG. 6 is a block diagram of a light detection device 1 according to a second example;
FIG. 7A is a circuit diagram illustrating a first specific example of a first amplifier of FIG. 6;
FIG. 7B is a circuit diagram illustrating a second specific example of the first amplifier of FIG. 6;
FIG. 7C is a circuit diagram illustrating a third specific example of the first amplifier and the second amplifier of FIG. 6;
FIG. 7D is a circuit diagram illustrating a fourth specific example of the first amplifier of FIG. 6;
FIG. 8 is a block diagram illustrating a first modification of the light detection device of FIG. 6;
FIG. 9 is a block diagram illustrating a second modification of the light detection device of FIG. 6;
FIG. 10 is a block diagram of a light detection device according to a third example;
FIG. 11 is a circuit diagram illustrating a specific example of an active quenching circuit;
FIG. 12 is a schematic cross-sectional view of a light detection device according to a fourth example;
FIG. 13 is a cross-sectional view more specifically illustrating the cross-sectional structure of FIG. 12;
FIG. 14 is a plan view of the light detection device of FIG. 13;
FIG. 15 is a cross-sectional view according to a first modification of FIG. 12;
FIG. 16 is a cross-sectional view according to a second modification of FIG. 12;
FIG. 17 is a cross-sectional view according to a third modification of FIG. 12; and
FIG. 18 is a block diagram illustrating a schematic configuration of an electronic device 2 including a light receiving unit incorporating a light detection device.

DETAILED DESCRIPTION

According to one example, a light detection device comprising:

a light receiving element that photoelectrically converts incident light; and
a plurality of transistors that controls a bias voltage applied to the light receiving element and controlling reading of an output signal of the light receiving element,

wherein the plurality of transistors comprise at least one or more transistors having a first withstand voltage and one or more transistors having a second withstand voltage higher than the first withstand voltage.

An avalanche photodiode (hereinafter, APD) is one of light detection elements that convert received light into an electrical signal. In particular, an element that operates the APD in Geiger mode is called a single photon avalanche diode (SPAD). The SPAD has an ability to detect weak light of one photon. However, an operation state of the SPAD changes after detecting photons, and light cannot be detected with high sensitivity. Therefore, it is necessary to reset the SPAD by connecting a quenching circuit to the SPAD. The quenching circuit resets the SPAD by applying a reverse bias voltage higher than an anode terminal to a cathode terminal of the SPAD. In the SPAD, since the sensitivity is improved as the reverse bias voltage is increased, it is necessary to apply a reverse bias voltage with which an optimal sensitivity can be obtained to the cathode terminal of the SPAD.

As described above, each time the SPAD detects light, the SPAD needs to be brought into a reset state and a desired reverse bias voltage needs to be applied to the SPAD, so that power consumption increases. In particular, in a light receiving cell array in which a large number of SPADs are arranged on a two-dimensional plane, power consumption increases as the number of SPADs increases. In the SPAD, since there is a crosstalk phenomenon in which light is emitted while an avalanche current is generated and disturbance is applied to surrounding SPADs, it is better not to bring the SPAD that does not need to be operated in the light receiving array into the reset state. Therefore, it is conceivable to apply a reverse bias voltage only to some SPADs in the light receiving cell array.

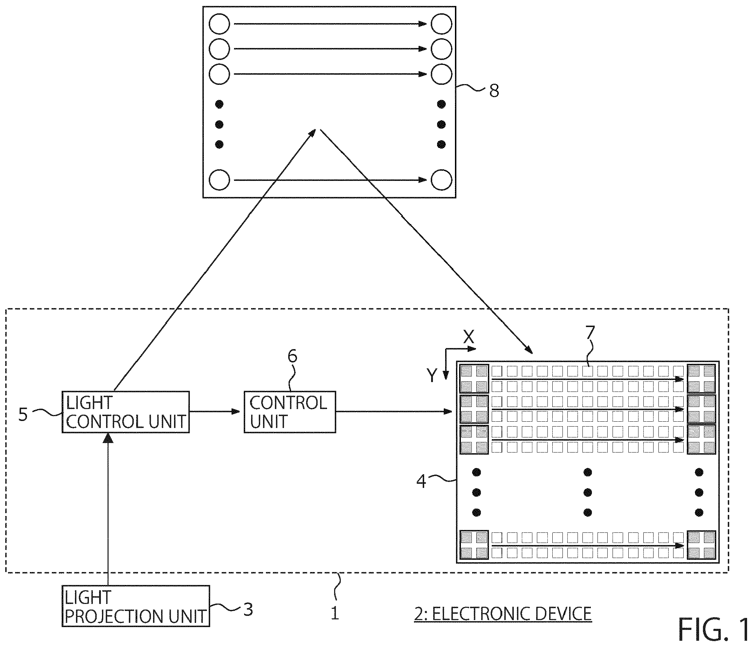

FIG. 1 is a block diagram illustrating a schematic configuration of an electronic device 2 including a light detection device 1 according to the present example. The electronic device 2 of FIG. 1 includes the light detection device 1 and a light projection unit 3. The light detection device 1 includes a light receiving cell array 4, a light control unit 5, and a control unit 6.

The light receiving cell array 4 includes a plurality of light receiving elements 7 individually switchable between an on state in which light is received and an off state in which light is not received. In the example of FIG. 1, a plurality of light receiving elements 7 are arranged in the two-dimensional direction (a first direction X and a second direction Y), but may be arranged only in the one-dimensional direction (for example, the first direction X). The light projection unit 3 projects light toward a target 8. The light projection unit 3 scans light within a predetermined range.

The control unit 6 acquires information on the scanning direction and speed of the light from the light projection unit 3 from the light control unit 5, and dynamically switches the light receiving element 7 to be turned on based on the acquired information. For example, the control unit 6 can switch the light receiving element 7 to be turned on according to the scanning direction and the scanning speed of the light.

As described above, the control unit 6 according to the present example turns on only the light receiving element 7 on which desired reflected light is likely to be incident, and turns off the other light receiving elements 7 in the light receiving cell array 4. The output signal of the light receiving element 7 in the off state is always zero, and there is no possibility that the light receiving element 7 in the off state outputs noise. This enables asynchronous control of each light receiving element 7 in the light detection device 1.

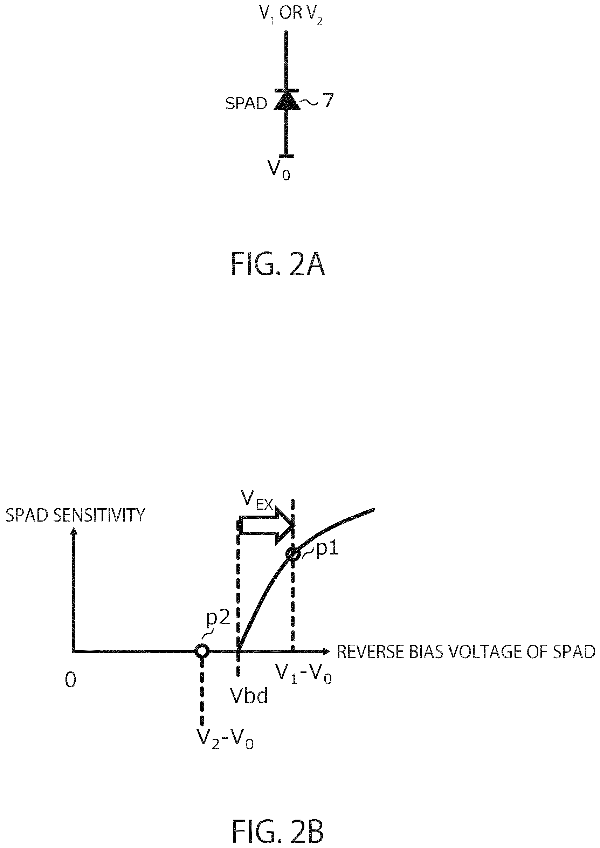

FIG. 2A is a diagram illustrating a voltage applied to the SPAD 7. Note that, in the present specification, the SPAD 7 and the light receiving element 7 are denoted by the same reference numerals. In FIG. 2A, the anode voltage of the SPAD 7 is V0, and the cathode voltage is V1 or V2. A state in which the cathode voltage of the SPAD 7 is made higher than the anode voltage is a reverse bias state.

FIG. 2B is a diagram illustrating a relationship between a reverse bias voltage and sensitivity of the SPAD 7. In FIG. 2B, the horizontal axis represents a reverse bias voltage of the SPAD 7, and the vertical axis represents sensitivity of the SPAD 7. In FIG. 2B, when a reverse bias voltage Vbd is a breakdown voltage (threshold voltage) and the reverse bias voltage becomes equal to or greater than Vbd, the SPAD 7 can be ignited. Note that the ignition means that the SPAD 7 absorbs light to generate an avalanche current. In FIG. 2B, the differential voltage between the reverse bias voltage and the breakdown voltage Vbd is VEX. As the differential voltage VEX increases, the sensitivity of the SPAD 7 increases. More specifically, until the differential voltage VEX reaches a certain level, the sensitivity of the differential voltage VEX and the sensitivity of the SPAD 7 are substantially proportional, and when the differential voltage VEX reaches a certain level or more, the sensitivity of the SPAD 7 is saturated.

For example, when light is detected when a reverse bias voltage of p1 on the curve of FIG. 2B is applied to the SPAD 7, the SPAD 7 is ignited and generates a large avalanche current. The stop condition of the avalanche current is that the reverse bias voltage of the SPAD 7 becomes equal to or less than the breakdown voltage Vbd. Therefore, in the SPAD 7, the cathode voltage decreases until the reverse bias voltage becomes equal to or lower than the breakdown voltage Vbd after ignition. Therefore, the cathode voltage of the SPAD 7 changes with a voltage width of VEX or more. Therefore, the transistor used in the circuit that controls the reverse bias voltage of the SPAD 7 needs to have a withstand voltage that does not break even when a voltage corresponding to a change in the cathode voltage of the SPAD 7 is applied. The withstand voltage refers to a maximum voltage that can be applied across the terminals of the transistor. If a voltage exceeding the withstand voltage is applied across the terminals of the transistor, the transistor may be damaged.

On the other hand, since the signal amplitude of the signal output from the SPAD 7 is small, it is necessary to amplify the signal using an amplifier. If the withstand voltage of the transistor used for this amplifier is increased, the driving capability of the amplifier cannot be increased. Therefore, it is desirable to lower the withstand voltage of the transistor used for the amplifier that amplifies the signal from the SPAD 7.

As described above, it is necessary to mix a transistor having a high withstand voltage and a transistor having a low withstand voltage in the control circuit that controls the SPAD 7.

As described above, in order to improve the sensitivity of the SPAD 7, it is necessary to increase the reverse bias voltage applied to the cathode terminal of the SPAD 7 as much as possible. However, if a high reverse bias voltage is always applied to the cathode terminals of all the SPADs 7 in the light receiving cell array 4, the following problem occurs.

1) Since the amplifier connected to the cathode terminal of the SPAD 7 needs to be always operated for all the light receiving cells, power consumption increases. When the operation of the amplifier is stopped, when the SPAD 7 is ignited, the voltage of the input node of the amplifier rapidly decreases to the anode voltage of the SPAD 7, and the amplifier may be broken.

2) When the SPAD 7 is ignited, there is a possibility that the SPAD 7 itself emits light, crosstalk that causes disturbance around the ignited SPAD 7 occurs, and light detection accuracy of the light detection device 1 decreases.

As described above, in the light receiving cell array 4 in which the plurality of light receiving cells including the SPAD 7 is arranged, it is desirable to reliably turn off the light receiving cell in which light reception is not assumed.

(First example of light detection device 1)

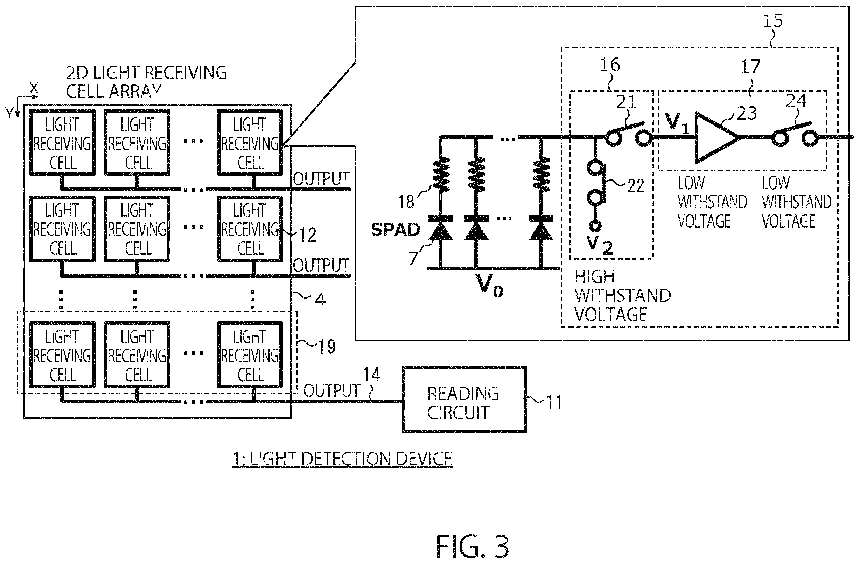

FIG. 3 is a block diagram of a first example of the light detection device 1 for achieving asynchronous control of the light receiving element 7 as illustrated in FIG. 1. The light detection device 1 of FIG. 3 includes a light receiving cell array 4 similar to that of FIG. 1 and a reading circuit 11. The light receiving cell array 4 includes a plurality of light receiving cells 12 arranged in the first direction X and the second direction Y. A plurality of light receiving cell groups 19 including a plurality of light receiving cells 12 arrayed in the first direction X are arranged in the second direction Y. Output wiring 14 is provided in association with each light receiving cell group 19. The output signal of each light receiving cell 12 in the light receiving cell group 19 is transmitted to the reading circuit 11 via the corresponding output wiring 14.

Each light receiving cell 12 includes a light receiving element 7 and a plurality of transistors. The light receiving element 7 is an element that photoelectrically converts incident light. Hereinafter, an example in which the SPAD 7 is used as the light receiving element 7 will be mainly described. The plurality of transistors are used for control of a bias voltage applied to the SPAD 7 and read control of an output signal of the SPAD 7. The plurality of transistors include two or more transistors having different withstand voltages.

More specifically, each light receiving cell 12 includes a plurality of SPADs 7 and a control circuit 15. The control circuit 15 includes a bias control circuit 16 and an output circuit 17.

In the example of FIG. 3, a resistance element 18 is connected in series to the SPAD 7. The resistance element 18 is also called a quench resistor. In the following description, the "one end of the light receiving element 7" may refer to the cathode terminal of the SPAD 7 or may refer to one end of the resistance element 18 connected in series to the SPAD 7. Both cases will be described as "one end of the light receiving element 7" in the present specification.

The bias control circuit 16 switches between application of the first bias voltage V1 to the light receiving element 7 and application of the second bias voltage V2 lower than the first bias voltage V1 to the light receiving element 7. The first bias voltage V1 and the second bias voltage V2 are reverse bias voltages applied to one end of the light receiving element 7, and the first bias voltage V1 is higher than the second bias voltage V2.

The output circuit 17 amplifies the output signal of the light receiving element 7 in a state where the first bias voltage V1 is applied to the light receiving element 7. The bias control circuit 16 includes a transistor having a withstand voltage higher than that of the transistor in the output circuit 17.

Here, as illustrated in FIG. 2B, when the anode voltage of the SPAD 7 V0 is set to 0V, the first bias voltage V1 is a voltage higher than the breakdown voltage Vbd. The second bias voltage V2 is lower than a breakdown voltage at which the light receiving element 7 absorbs light by light irradiation to start generating a photoelectric conversion current.

More specifically, the bias control circuit 16 in FIG. 3 includes a first switching circuit 21 and a second switching circuit 22. The first switching circuit 21 switches whether to apply the first bias voltage V1 to one end of the light receiving element 7. The second switching circuit 22 switches whether to apply the second bias voltage V2 to one end of the light receiving element 7.

The output circuit 17 includes an amplifier 23 that amplifies the output signal of the light receiving element 7 in a state where the first bias voltage V1 is applied to one end of the light receiving element 7. The first switching circuit 21 and the second switching circuit 22 include transistors having higher withstand voltages than other transistors in the control circuit 15. A third switching circuit 24 including a low withstand voltage transistor may be provided at a subsequent stage of the amplifier 23.

As described above, the control circuit 15 includes transistor having a high withstand voltages (transistors of a first type) and low withstand voltages (transistors of a second type). The transistor having a high withstand voltage is a transistor having a withstand voltage higher than the withstand voltage of any one transistor of the plurality of transistors in the control circuit 15 that controls the SPAD 7. The transistor having a low withstand voltage is a transistor having a withstand voltage lower than the withstand voltage of any one transistor of the plurality of transistors in the control circuit 15 that controls the SPAD 7. The withstand voltage of the plurality of transistors provided in the control circuit 15 that controls the SPAD 7 is two or more, and for example, three types or four types of transistors having different withstand voltages may be provided in the control circuit 15. Hereinafter, an example in which two types of transistors having different withstand voltages are provided in the control circuit 15 will be mainly described. The control circuit 15 of the present example includes one or more transistors having a first withstand voltage and one or more transistors having a second withstand voltage higher than the first withstand voltage.

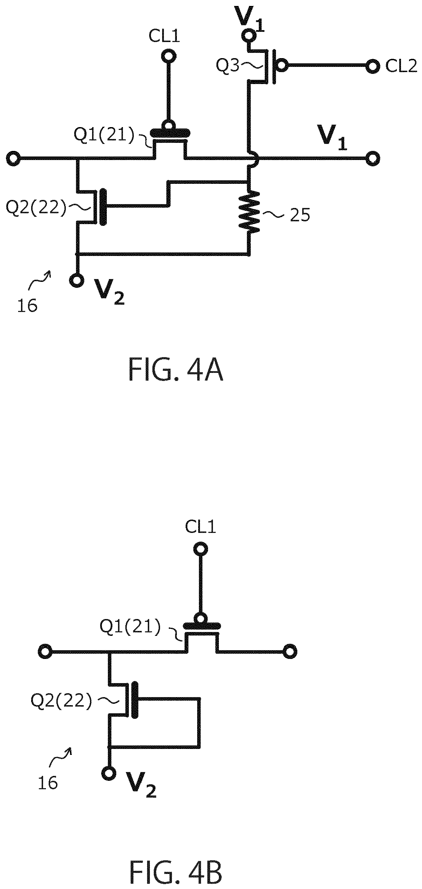

FIG. 4A is a circuit diagram illustrating a first specific example of the bias control circuit 16. The first switching circuit 21 in the bias control circuit 16 of FIG. 4A includes a PMOS transistor Q1 connected between one end of the light receiving element 7 and an input node of the amplifier 23. A first control signal CL1 is input to the gate of the PMOS transistor Q1. The input node of the amplifier 23 is controlled to be the first bias voltage V1 when the light receiving element 7 is not ignited. The PMOS transistor Q1 is turned on when the first control signal CL1 is at a low level, and applies the first bias voltage V1 to one end of the light receiving element 7.

The second switching circuit 22 in the bias control circuit 16 of FIG. 4A includes an NMOS transistor Q2 that switches whether to apply the second bias voltage V2 to one end of the light receiving element 7, a resistance element 25 connected between the gate and the source of the NMOS transistor Q2, and a PMOS transistor Q3 that controls the gate voltage of the NMOS transistor Q2. A second control signal CL2 is input to the gate of the PMOS transistor Q3. When the second control signal CL2 becomes the low level, the PMOS transistor Q3 is turned on, the gate of the NMOS transistor Q2 becomes the high level and is turned on, and the second bias voltage V2 is applied to one end of the light receiving element 7.

Since the PMOS transistor Q1 and the NMOS transistor Q2 are not simultaneously turned on, the first bias voltage V1 or the second bias voltage V2 is applied to one end of the light receiving element 7. The first control signal CL1 and the second control signal CL2 are signals in a voltage range of first bias voltages V1 to (V1-a). The voltage a is a voltage higher than the threshold voltage of the PMOS transistors Q2, Q3 and equal to or lower than the withstand voltage of the transistor in the amplifier 23. The first control signal CL1 and the second control signal CL2 are generated by a control circuit (not illustrated) including a low withstand voltage transistor.

FIG. 4B is a circuit diagram illustrating a second specific example of the bias control circuit 16. The first switching circuit 21 in the bias control circuit 16 of FIG. 4B includes the PMOS transistor Q1 as similar to FIG. 4A. The second switching circuit 22 in the bias control circuit 16 of FIG. 4B includes the NMOS transistor Q2. The gate and the source of the NMOS transistor Q2 are short-circuited, and function as a diode. The second bias voltage V2 is applied to the source of the NMOS transistor Q2, and when the PMOS transistor Q1 is turned off, a voltage approximate to the second bias voltage V2 is applied to one end of the light receiving element 7.

When the PMOS transistor Q1 is turned off, the first bias voltage V1 is applied to one end of the light receiving element 7 at that time, and the light receiving element 7 can be ignited. When the light receiving element 7 is ignited, the voltage at one end of the light receiving element 7 decreases, and when the voltage decreases to a voltage equal to or lower than the breakdown voltage, the light receiving element 7 cannot be ignited, and one end of the light receiving element 7 becomes substantially equal to the second bias voltage V2.

The bias control circuit 16 of FIG. 4B has a simpler circuit configuration than the bias control circuit 16 of FIG. 4A, but is ignited until one end of the light receiving element 7, which should not be ignited, becomes equal to or lower than the breakdown voltage, and thus, may adversely affect the ignition of other light emitting elements.

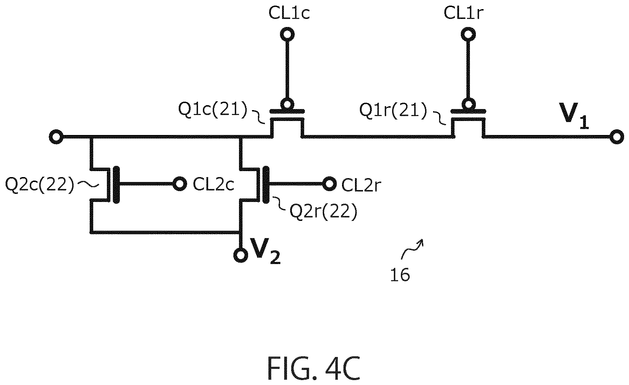

FIG. 4C is a circuit diagram illustrating a third specific example of the bias control circuit 16. The first switching circuit 21 in the bias control circuit 16 of FIG. 4C includes two PMOS transistors Q1c, Q1r cascode-connected between one end of the light receiving element 7 and the input node of the amplifier 23. One PMOS transistor Q1c is turned on when the first control signal CLc1 is at a low level, and another PMOS transistor Q1r is turned on when the first control signal CLr1 is at a low level.

The second switching circuit 22 in the bias control circuit 16 of FIG. 4C includes two NMOS transistors Q2c, Q2r that switch whether to apply the second bias voltage V2 to one end of the light receiving element 7. One NMOS transistor Q2c is turned on when the second control signal CLc2 is at a low level, and another NMOS transistor Q2r is turned on when the second control signal CLr2 is at a low level.

The PMOS transistor Q1c and the NMOS transistor Q2c are turned on when a light receiving element group at a specific position in the first direction X where the light receiving element 7 that is a light detection target is located is selected. The PMOS transistor Q1r and the NMOS transistor Q2r are turned on when a light receiving element group at a specific position in the second direction Y where the light receiving element 7 that is a light detection target is located is selected.

Since the first switching circuit 21 and the second switching circuit 22 in the bias control circuit 16 of FIG. 4C can apply the first bias voltage V1 or the second bias voltage V2 to one end of the light receiving element 7 in a specific light receiving cell 12 in the light receiving cell array 4, a dedicated circuit for selecting the light receiving cell 12 to be turned on becomes unnecessary. However, it is necessary to provide four transistor having a high withstand voltages Q1c, Q1r, Q2c, Q2r for each light receiving cell 12, making it difficult to downsize the light receiving cell 12.

The amplifier 23 in the output circuit 17 of FIG. 3 is also called a buffer amplifier. Hereinafter, the amplifier 23 may be referred to as a buffer amplifier 23 with the same reference numerals. The reason why the buffer amplifier 23 is required is as follows. When the resolution of the light receiving cell array 4 is increased, the number of light receiving cells 12 connected to one output wiring 14 increases, and the parasitic capacitance of the output wiring 14 increases. As the parasitic capacitance of the output wiring 14 increases, the noise of the reading circuit 11 increases. When the SPAD 7 in the light receiving cell 12 is downsized, the current amount at the time of ignition decreases, and is buried in the noise of the reading circuit 11, and the light detection accuracy of each light receiving cell 12 decreases.

On the other hand, since the input terminal of the buffer amplifier 23 is connected only to the corresponding SPAD 7, the parasitic capacitance is small and the noise is small. Therefore, the buffer amplifier 23 can output a current or a voltage larger than the noise level of the reading circuit 11. For the above reason, the buffer amplifier 23 is essential in a case where the number of SPADs 7 in the light receiving cell array 4 is increased by downsizing the SPAD 7. The buffer amplifier 23 can be configured by a fine CMOS process as described later.

Since a plurality of configurations are conceivable as a specific configuration of the buffer amplifier 23, two representative configurations will be described below.

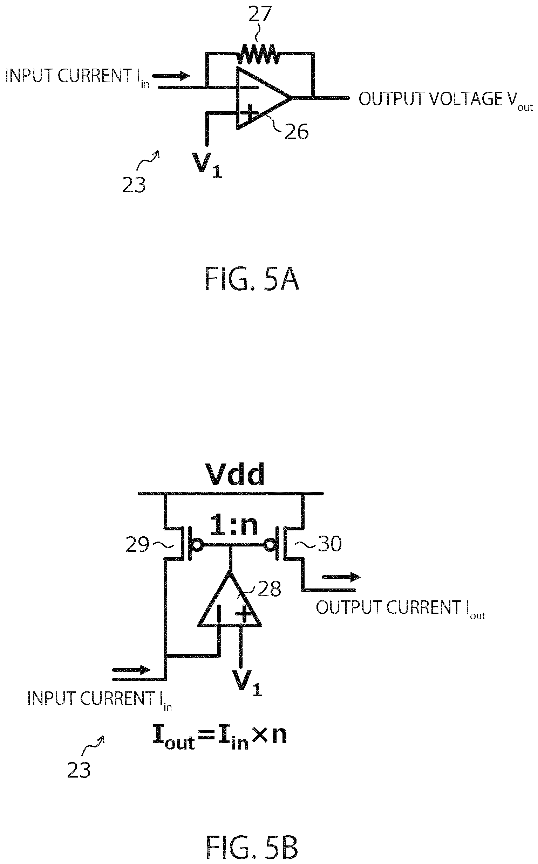

FIG. 5A is a circuit diagram of a first example of the buffer amplifier 23. The buffer amplifier 23 in FIG. 5A is a transimpedance amplifier for current input and voltage output. The buffer amplifier 23 of FIG. 5A includes a differential input amplifier 26 and a resistance element 27 connected between an inverting input terminal and an output terminal of the differential input amplifier 26. An input current from one end of the light receiving element 7 is supplied to an inverting input terminal of the differential input amplifier 26. The first bias voltage V1 is applied to the non-inverting input terminal of the differential input amplifier 26. The buffer amplifier 23 in FIG. 5A outputs a voltage obtained by multiplying the input current by the resistance value of the resistance element 27.

FIG. 5B is a circuit diagram of a second example of the buffer amplifier 23. The buffer amplifier 23 in FIG. 5B is a current output amplifier for current input and current output. The buffer amplifier 23 of FIG. 5B includes a differential input amplifier 28 and two PMOS transistors 29, 30 having a current mirror configuration. The size ratio of the PMOS transistors 29, 30 is 1: n. The inverting input terminal of the differential input amplifier 28 is connected to one end of the light receiving element 7, and the current flowing through the one end of the light receiving element 7 flows to the inverting input terminal of the differential input amplifier 28. The first bias voltage V1 is applied to the non-inverting input terminal of the differential input amplifier 28. The output terminal of the differential input amplifier 28 is connected to the gates of the two PMOS transistors 29, 30. A power supply voltage Vdd is applied to the sources of the two PMOS transistors 29, 30. The drain of one PMOS transistor 29 is connected to the inverting input terminal of the differential input amplifier 28. An output current is output from the drain of another PMOS transistor 30.

The buffer amplifier 23 of FIG. 5B can obtain an output current Iout that is n times an input current Iin by adjusting a mirror ratio n of the current mirror circuit.

As described above, in the light detection device 1 according to the first example, the transistor having a high withstand voltage and the transistor having a low withstand voltage are provided in the control circuit 15 that controls the light receiving element 7 in the light receiving cell 12. As a result, a-high-withstand voltage transistor can be used to apply a reverse bias voltage optimal for improving the sensitivity of the SPAD 7 to the cathode terminal of the SPAD 7, and a transistor having a low withstand voltage can be used to amplify the output signal from the SPAD 7 by the buffer amplifier 23.

(Second example of light detection device 1)

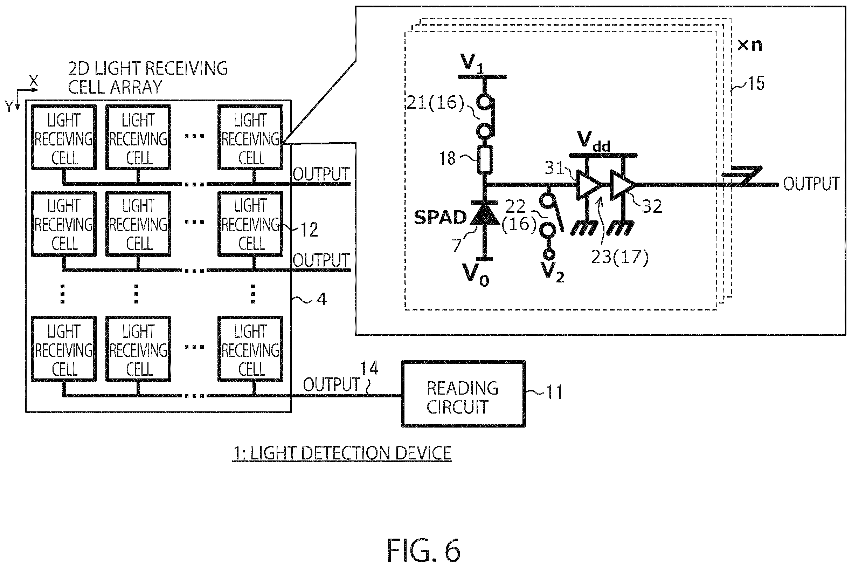

FIG. 6 is a block diagram of the light detection device 1 according to a second example. In FIG. 6, the same components as those in FIG. 3 are denoted by the same reference numerals, and differences will be mainly described below.

The light detection device 1 of FIG. 6 is different from that of FIG. 3 in the circuit configuration of the light receiving cell 12 in the light receiving cell array 4.

The light receiving cell 12 of FIG. 6 includes the light receiving element 7 such as the SPAD 7 and a control circuit 15. The control circuit 15 includes a bias control circuit 16 and an output circuit 17. The bias control circuit 16 includes a first switching circuit 21 and a second switching circuit 22.

The first switching circuit 21 and the resistance element 18 are connected in series between a node to which the first bias voltage V1 is applied and the cathode terminal of the SPAD 7. The resistance element 18 is also referred to as a quench resistor. In FIG. 3, the input node of the buffer amplifier 23 is set to the first bias voltage V1, but in FIG. 6, the first bias voltage V1 is applied to a place other than the input node of the buffer amplifier 23.

The second switching circuit 22 is connected between a node to which the second bias voltage V2 is applied and the cathode terminal of the SPAD 7. In FIG. 3, the second bias voltage V2 is applied to the cathode terminal of the SPAD 7 via the resistance element 18, but in FIG. 6, the second bias voltage V2 is directly applied to the cathode terminal of the SPAD 7 without the resistance element 18.

The output circuit 17 of FIG. 6 includes a first amplifier 31 and a second amplifier 32 connected in series. The first amplifier 31 amplifies the output signal of the SPAD 7. The second amplifier 32 amplifies the output signal of the first amplifier 31. The transistor in the first amplifier 31 has a higher withstand voltage than that of the transistor in the second amplifier 32. The second amplifier 32 has higher driving capability than that of the first amplifier 31.

An input node of the first amplifier 31 is connected to the cathode terminal of the SPAD 7 and greatly changes within a range of voltages V1 to V2. Therefore, it is desirable that the transistors in the first amplifier 31 have a high withstand voltage. Although the transistor having a high withstand voltage has a large size, it is difficult to increase the driving capability. For this reason, in order to increase the driving capability of the transistor having a high withstand voltage, it is necessary to further increase the size, and the size of the light receiving cell 12 is increased. Therefore, in FIG. 6, the second amplifier 32 including a transistor having a low withstand voltage is provided at a subsequent stage of the first amplifier 31. The second amplifier 32 can be manufactured using a microfabrication process, and the amplification factor can be relatively easily increased.

As described above, by configuring the buffer amplifier 23 with the first amplifier 31 and the second amplifier 32, the size of the entire buffer amplifier 23 can be reduced while increasing the withstand voltage and the amplification factor.

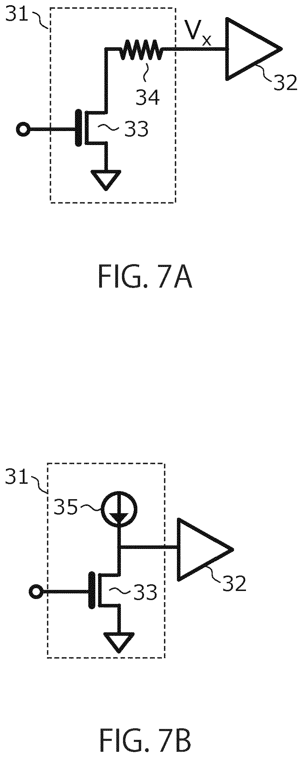

FIG. 7A is a circuit diagram illustrating a first specific example of the first amplifier 31 of FIG. 6. The first amplifier 31 of FIG. 7A includes a NMOS transistor 33 having a high withstand voltage and a resistance element 34. The resistance element 34 is connected between the drain of the NMOS transistor 33 and the input node of the second amplifier 32. The source of the NMOS transistor 33 is connected to a ground node. The gate of the NMOS transistor 33 is connected to the cathode terminal of the SPAD 7.

In the first amplifier 31 of FIG. 7A, when the cathode voltage of the SPAD 7 exceeds the threshold voltage of the NMOS transistor 33, the NMOS transistor 33 is turned on, and the drain voltage of the NMOS transistor 33 decreases to the ground voltage. A current having a value obtained by dividing a voltage difference between the voltage of the input node of the second amplifier 32 and the drain voltage of the NMOS transistor 33 by the resistance value of the resistance element 34 flows through the input node of the second amplifier 32.

In FIG. 7A, the first amplifier 31 is configured using the NMOS transistor 33 having a high withstand voltage, but can also be configured using a PMOS transistor having a high withstand voltage.

FIG. 7B is a circuit diagram illustrating a second specific example of the first amplifier 31 of FIG. 6. The first amplifier 31 of FIG. 7B includes a current source 35 instead of the resistor of FIG. 7A. The current source 35 is connected to the drain of the NMOS transistor 33. The second amplifier 32 is connected to the drain of the NMOS transistor 33. The current from the current source 35 flows to the drain of the NMOS transistor 33 and the input node of the second amplifier 32, but the current flowing to the drain of the NMOS transistor 33 changes due to the voltage of the cathode terminal of the SPAD 7, and accordingly, the current flowing to the input node of the second amplifier 32 also changes. Instead of the NMOS transistor 33 in FIG. 7B, a PMOS transistor having a high withstand voltage can also be used.

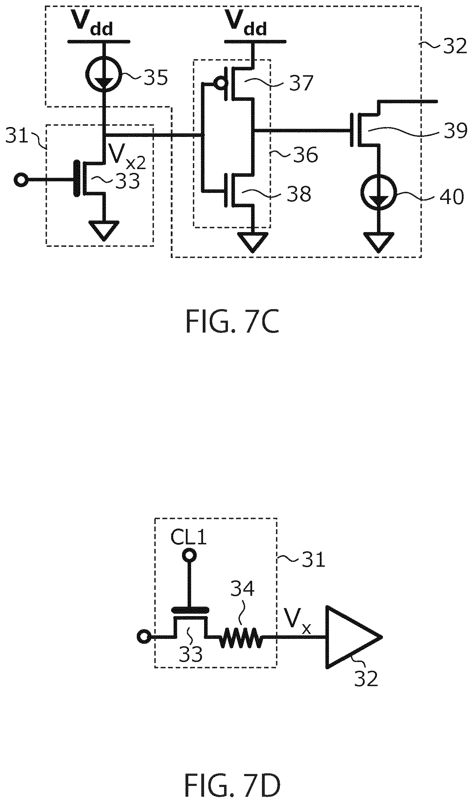

FIG. 7C is a circuit diagram illustrating a third specific example of the first amplifier 31 and the second amplifier 32 of FIG. 6. First amplifier 31 in FIG. 7C has the same configuration as that of the first amplifier 31 in FIG. 7B. The second amplifier 32 of FIG. 7C includes the current source 35, a PMOS transistor 37 and an NMOS transistor 38 constituting an inverter 36, an NMOS transistor 39 connected to a subsequent stage of the inverter 36, and a current source 40 connected to a source of the NMOS transistor 39.

The NMOS transistor 33 in the first amplifier 31 has a high withstand voltage, whereas each transistor in the second amplifier 32 has a low withstand voltage. The NMOS transistor 33 in the first amplifier 31 is excellent in withstand voltage but poor in driving capability, and thus the output signal of the first amplifier 31 is inverted by the inverter 36 in the second amplifier 32 to improve the driving capability. The driving capability of the second amplifier 32 may be further enhanced by further complicating the circuit configuration of the second amplifier 32 or devising a manufacturing process.

FIG. 7D is a circuit diagram illustrating a fourth specific example of the first amplifier 31 of FIG. 6. The first amplifier 31 of FIG. 7 includes a high-withstand-voltage NMOS transistor 33 and a resistance element 34. The drain of the NMOS transistor 33 is connected to the cathode terminal of the SPAD 7. The resistance element 34 is connected between the source of the NMOS transistor 33 and the input node of the second amplifier 32. The resistance element 34 can convert the cathode voltage of the SPAD 7 into a current and input the current to the second amplifier 32. The first control signal CL1 similar to that in FIG. 4A is input to the gate of the NMOS transistor 33. Instead of the NMOS transistor 33 in the first amplifier 31 of FIG. 7D, a PMOS transistor 37 may be used.

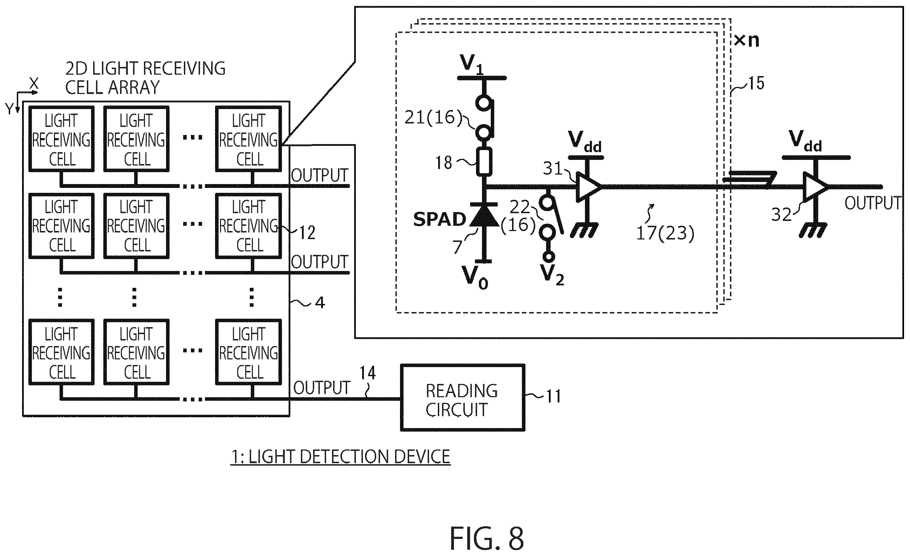

In FIG. 6, the first amplifier 31 and the second amplifier 32 are provided inside each light receiving cell 12, but the second amplifier 32 may be shared by the plurality of light receiving cells 12. FIG. 8 is a block diagram illustrating a first modification of the light detection device 1 of FIG. 6. The light detection device 1 of FIG. 8 has the same circuit operation as that of FIG. 6, but is different from the light receiving cell 12 of FIG. 6 in that the second amplifier 32 is provided outside the light receiving cell 12 and the second amplifier 32 is shared by the plurality of light receiving cells 12. The light receiving cell 12 in FIG. 8 outputs an output signal of the first amplifier 31. The output signals of the light receiving cell group 19 arranged in the first direction X are integrated into one wiring and input to the second amplifier 32. The output signal of the second amplifier 32 is input to the reading circuit 11 via the output wiring 14.

As illustrated in FIG. 8, by sharing the second amplifier 32 in the buffer amplifier 23 among the plurality of light receiving cells 12, the internal configuration of each light receiving cell 12 can be simplified, and the light receiving cell 12 can be downsized, so that the resolution of the light receiving cell array 4 can be improved.

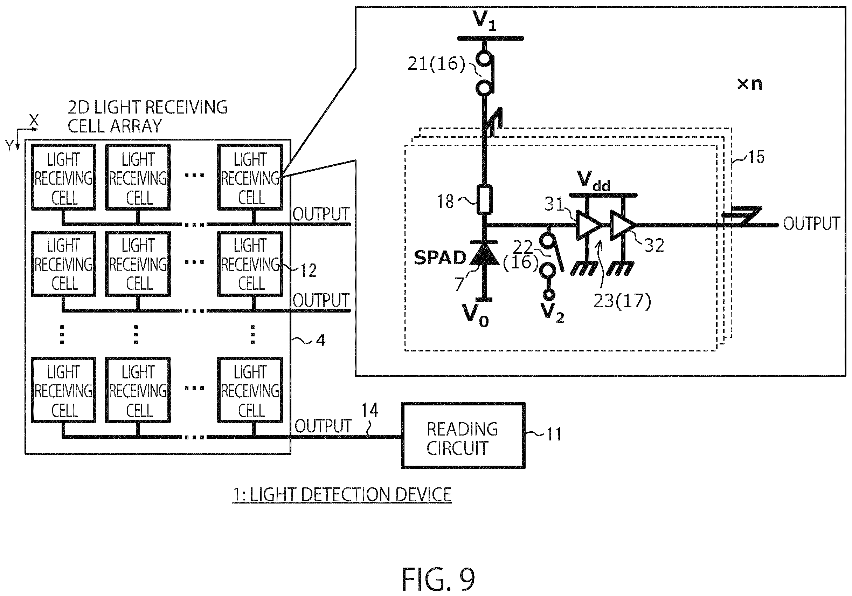

In FIG. 6, the first switching circuit 21 is provided inside the light receiving cell 12, but the first switching circuit 21 may be shared by the plurality of light receiving cells 12. FIG. 9 is a block diagram illustrating a second modification of the light detection device 1 of FIG. 6. The light detection device 1 of FIG. 9 has the same circuit operation as that of FIG. 6, but is different from the light receiving cell 12 of FIG. 6 in that the first switching circuit 21 is provided outside the light receiving cell 12 and the first switching circuit 21 is shared by the plurality of light receiving cells 12.

As illustrated in FIG. 9, by sharing the first switching circuit 21 in the buffer control circuit 15 by the plurality of light receiving cells 12, the internal configuration of each light receiving cell 12 can be simplified, and the light receiving cell 12 can be downsized, so that the resolution of the light receiving cell array 4 can be improved.

As described above, in the second example, since the buffer amplifier 23 provided in the output circuit 17 in the light receiving cell 12 includes the first amplifier 31 having the transistor having a high withstand voltage and the second amplifier 32 having the transistor having a low withstand voltage, there is no possibility that the buffer amplifier 23 is destroyed even if the cathode voltage of the SPAD 7 greatly changes, and by configuring the second amplifier 32 with the transistor having a low withstand voltage, it is possible to obtain sufficient driving capability without increasing the size of the buffer amplifier 23.

(Third example of light detection device 1)

The light detection device 1 according to the first and second examples described above includes a passive quenching circuit, but can also be applied to the light detection device 1 including an active quenching circuit. The passive quenching circuit performs reset by connecting the resistance element 18 in series to the SPAD 7 and causing a current to flow through the SPAD 7 via the resistance element 18. The passive quenching circuit has a simple circuit configuration, but has a problem of slow operation. On the other hand, the active quenching circuit forcibly causes a current to flow through the SPAD 7 using a transistor or the like, and can perform the reset operation of the SPAD 7 at high speed.

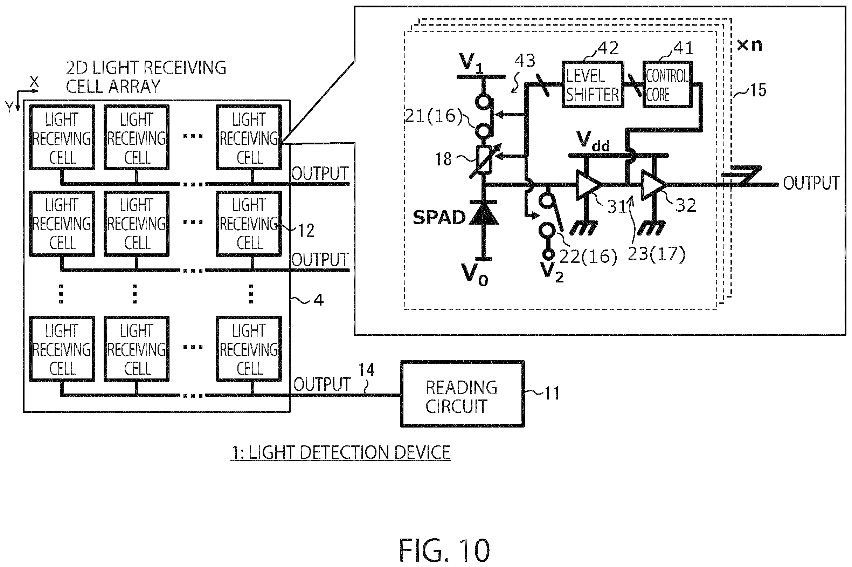

FIG. 10 is a block diagram of the light detection device 1 according to a third example. The light detection device 1 of FIG. 10 is different from that of FIG. 6 and the like in the internal configuration of the light receiving cell 12. The light receiving cell 12 of FIG. 10 includes a control core 41 and a level shifter 42 in addition to the configuration of the light receiving cell 12 of FIG. 6. The light receiving cell 12 of FIG. 10 includes an active quenching circuit 43. The active quenching circuit 43 includes the first switching circuit 21 and the resistance element 18, and the switching timing of the first switching circuit 21 can be arbitrarily adjusted and the resistance value of the resistance element 18 can be adjusted.

The control core 41 outputs a control signal for adjusting the switching timing of the first switching circuit 21 and the resistance value of the resistance element 18 according to the output signal of the first amplifier 31 in the buffer amplifier 23. A voltage level of the control signal output from the control core 41 is converted by the level shifter 42, and the control signal is supplied to the first switching circuit 21 and the resistance element 18. According to the control signal converted by the level shifter 42, the first switching circuit 21 sets the timing to supply the first bias voltage V1 to one end of the resistance element 18, and the resistance element 18 adjusts the resistance value.

As described above, the performance (for example, dead time, crosstalk, dark count, and the like) of the SPAD 7 can be optimized by adjusting the switching timing of the first switching circuit 21 and the resistance value of the resistance element 18 by the control core 41.

The control core 41 is a small amplitude digital circuit, and is greatly different from the voltage change width of the cathode terminal of the SPAD 7. Therefore, the control signal output from the control core 41 cannot be directly input to the first switching circuit 21 or the resistance element 18. Therefore, it is necessary to convert the voltage level by the level shifter 42. By providing the level shifter 42, switching control of the first switching circuit 21 including a transistor having a high withstand voltage can be performed by a control signal output from the control core 41 including a transistor having a low withstand voltage. The level shifter 42 can be configured by a simple circuit that only converts the voltage level, and the number of transistors constituting the level shifter 42 is not so large. Therefore, even if a transistor having a high withstand voltage is included in the level shifter 42, the circuit scale of the light detection device 1 including the level shifter 42 is not so large.

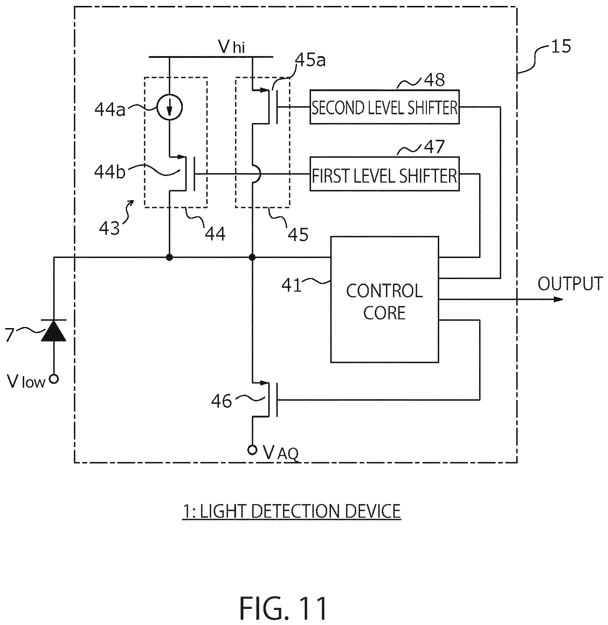

FIG. 11 is a circuit diagram illustrating a specific example of the active quenching circuit 43. The active quenching circuit 43 in FIG. 11 performs a forced reset operation on the SPAD 7 after the SPAD 7 detects light. The active quenching circuit 43 of FIG. 11 includes a first reset circuit 44, a second reset circuit 45, and an NMOS transistor 46. The first reset circuit 44 and the second reset circuit 45 are controlled by the control core 41. When the cathode voltage of the SPAD 7 decreases to a predetermined threshold voltage, the control core 41 turns on the NMOS transistor 46. As a result, the cathode voltage of the SPAD 7 is maintained at a predetermined voltage VAQ.

The first reset circuit 44 switches whether or not to set the on-resistance between a first voltage node Vhi and one end of the SPAD 7 (cathode terminal of the SPAD 7) to a first value. The first reset circuit 44 is configured by connecting a current source 44a and a first switch 44b in series. The current source 44a outputs a predetermined current. The current source 44a is provided to limit the current flowing through the cathode terminal of the SPAD 7. The first switch 44b switches whether the current output from the current source 44a flows to the cathode terminal of the SPAD 7. When the first switch 44b is on, the current output from the current source 44a flows to the cathode terminal of the SPAD 7 through the first switch 44b. The on-resistance of the first reset circuit 44 is the impedance of the first reset circuit 44 when the first switch 44b is on.

The second reset circuit 45 switches whether or not to set the on-resistance between the first voltage node Vhi and the cathode terminal of the SPAD 7 to a second value smaller than the first value. The second reset circuit 45 includes a second switch 45a. When the second switch 45a is on, a current flows from the first voltage node Vhi to the cathode terminal of the SPAD 7 through the second switch 45a. The on-resistance of the second reset circuit 45 is the impedance of the second reset circuit 45 when the second switch 45a is on. The second value that is the on-resistance of the second reset circuit 45 is smaller than the first value that is the on-resistance of the first reset circuit 44. Therefore, the current flowing from the second reset circuit 45 to the cathode terminal of the SPAD 7 when the second switch 45a is on is larger than the current flowing from the first reset circuit 44 to the cathode terminal of the SPAD 7 when the first switch 44b is on. In the present example, the period during which the on-resistance of the second reset circuit 45 becomes the second value is made shorter than the period during which the on-resistance of the first reset circuit 44 becomes the first value.

After the SPAD 7 detects light, the control core 41 causes the first reset circuit 44 to set the on-resistance between the first voltage node Vhi and the cathode terminal of the SPAD 7 to the first value, and then causes the second reset circuit 45 to set the on-resistance to the second value. More specifically, after the SPAD 7 detects light, the control core 41 maintains one end (cathode terminal) of the SPAD 7 at the first voltage, then sets the on-resistance to the first value in the first reset circuit 44, and then sets the on-resistance to the second value in the second reset circuit 45. Since the smaller the on-resistance, the easier the current flows, the current flowing through the cathode terminal of the SPAD 7 can be changed by switching the on-resistance between the first voltage node Vhi and the cathode terminal of the SPAD 7.

As described above, during the reset operation after the SPAD 7 detects light, the control core 41 first causes the limited current from the first reset circuit 44 to flow to the cathode terminal of the SPAD 7, and then causes the large current from the second reset circuit 45 to flow to the cathode terminal of the SPAD 7.

The control signal for the first switch 44b output from the control core 41 is input to the gate of the MOS transistor Q1 via the first level shifter 47. Similarly, the control signal for the second switch 45a output from the control core 41 is input to the gate of the MOS transistor Q2 via the second level shifter 48. The first level shifter 47 and the second level shifter 48 perform control to lower the voltage from the voltage level of the cathode voltage of the SPAD 7 to the gate voltage level of the MOS transistors Q1, Q2.

As described above, in the light detection device 1 according to the third example, when the active quenching circuit 43 in the light receiving cell 12 is controlled, the voltage level of the control signal output from the control core 41 is converted by the level shifter 42, and then the control signal is supplied to the first switching circuit 21 and the resistance element 18 in the active quenching circuit 43. Therefore, the first switching circuit 21 including the transistor having a high withstand voltage can be controlled without any problem using the control core 41 including the transistor having a low withstand voltage.

(Fourth example of light detection device 1)

The light detection device 1 according to the first to third examples described above includes a transistor having a high withstand voltage and a transistor having a low withstand voltage. The transistor having a high withstand voltage and the transistor having a low withstand voltage have greatly different applied voltages. The voltage applied to the cathode terminal of the SPAD 7 in the light receiving cell 12 greatly changes.

As described above, the light detection device 1 according to the first to third examples includes the light receiving element 7, the circuit including the transistor having a high withstand voltage, and the circuit including the transistor having a low withstand voltage, and the voltages applied to these circuits are greatly different from each other, so that it is necessary to perform element isolation for each circuit.

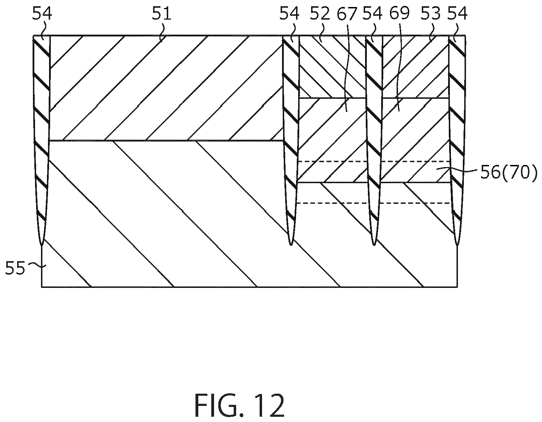

FIG. 12 is a schematic cross-sectional view of the light detection device 1 according to a fourth example. FIG. 12 illustrates an example in which circuits in the light detection device 1 are arranged on the same substrate. In the example of FIG. 12, a region (hereinafter, the light receiving element region) 51 in which the light receiving element 7 is formed, a circuit (hereinafter, referred to as a high withstand voltage unit) 52 including a transistor having a high withstand voltage, and a circuit (hereinafter, referred to as a low withstand voltage unit) 53 including a transistor having a low withstand voltage are arranged along the surface direction of the substrate. An element isolation layer 54 extending in the depth direction of the substrate is arranged between the light receiving element region 51 and the high withstand voltage unit 52 and between the high withstand voltage unit 52 and the low withstand voltage unit 53 to achieve electrical insulation. The element isolation layer 54 can be formed by forming a trench from the upper surface of the substrate by etching and filling the trench with an insulator.

A base layer 55 is arranged below the light receiving element region 51, and the base layer 55 is set to the same potential as the anode terminal of the SPAD 7. The cathode terminal of the SPAD 7 is provided on the upper surface side of the substrate.

The element isolation layer 54 in FIG. 12 does not extend to the back surface of the substrate, and the base layer 55 is arranged across the light receiving element region 51, the high withstand voltage unit 52, and the low withstand voltage unit 53. Therefore, the high withstand voltage unit 52 and the low withstand voltage unit 53 may be affected by the voltage of the base layer 55. Therefore, in FIG. 12, a protective layer (broken line portion in FIG. 12) 56 is arranged below each of the high withstand voltage unit 52 and the low withstand voltage unit 53, and the portion above the protective layer 56 is not affected by the voltage of the base layer 55.

Although a specific material of the protective layer 56 is not limited, in the example of FIG. 12, a depletion layer 70 extending on a pn junction surface is used as the protective layer 56. For example, the high withstand voltage unit 52 and the low withstand voltage unit 53 are formed of n-type semiconductor layers 67 and 69, respectively, the base layer 55 is formed of a p-type semiconductor layer, and a voltage higher than that of the p-type semiconductor layer is applied to the n-type semiconductor layers 67 and 69, and thereby, the depletion layer 70 is formed vertically from the pn junction surface formed at the interface between the n-type semiconductor layers 67 and 69 and the p-type semiconductor layer. By forming the depletion layer 70 between the base layer 55 and the high withstand voltage unit 52 and between the base layer 55 and the low withstand voltage unit 53, the voltage of the base layer 55 does not affect the high withstand voltage unit 52 and the low withstand voltage unit 53.

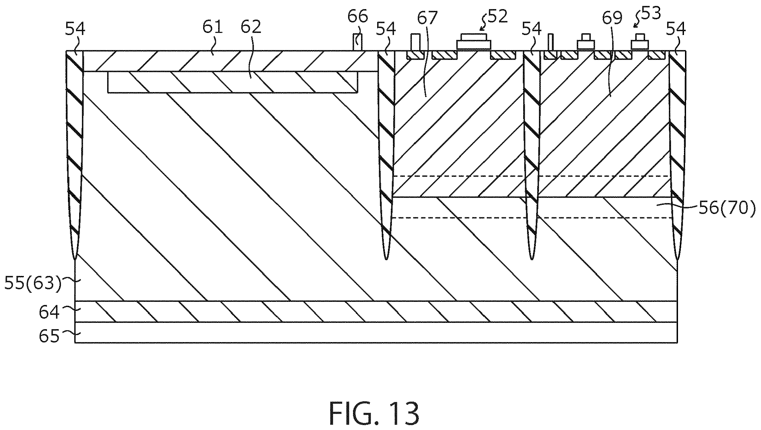

FIG. 13 is a cross-sectional view more specifically illustrating the cross-sectional structure of FIG. 12. As illustrated in FIG. 13, the light receiving element region 51 includes an n+ type semiconductor layer 61, a p+ type semiconductor layer 62, and a p- type semiconductor layer 63 from the upper surface side toward the lower surface side of the substrate. The n+ type semiconductor layer 61 and the p+ type semiconductor layer 62 constitute a photoelectric conversion unit. The p- type semiconductor layer 63 is the base layer 55 having the same potential as the anode electrode 65. The p+ type semiconductor layer 64 is arranged below the p- type semiconductor layer 63, and the anode electrode 65 is arranged below the p+ type semiconductor layer. On the upper surface side of the substrate of the light receiving element region 51, a cathode electrode 66 is arranged so as to be in contact with the n+ type semiconductor layer 61.

The high withstand voltage unit 52 includes the n- type semiconductor layer 67 and the p- type semiconductor layer 63 from the upper surface side toward the lower surface side of the substrate. A transistor having a high withstand voltage is formed on the upper surface side of the n- type semiconductor layer 67. FIG. 13 illustrates a cross-sectional structure of one transistor, but the number of transistors arranged at the high withstand voltage unit 52 and the low withstand voltage unit 53 is arbitrary. The low withstand voltage unit 53 includes the n-type semiconductor layer 69 and the p- type semiconductor layer 63 from the upper surface side toward the lower surface side of the substrate. The p-type semiconductor layer 68 located below the high withstand voltage unit 52 and the p-type semiconductor layer 63 located below the low withstand voltage unit 53 are integrally formed with the p- type semiconductor layer 63 constituting the base layer 55 located below the light receiving element region 51.

As illustrated in FIG. 13, the element isolation layer 54 that isolates the light receiving element region 51, the high withstand voltage unit 52, and the low withstand voltage unit 53 does not reach the back surface of the substrate, and the p-type semiconductor layer 63 constituting the base layer 55 is continuously formed from the light receiving element region 51 to the low withstand voltage unit 53 through the high withstand voltage unit 52. Therefore, the voltage applied to the p- type semiconductor layer 63 may affect the high withstand voltage unit 52 and the low withstand voltage unit 53. Therefore, in FIG. 13, in the high withstand voltage unit 52 and the low withstand voltage unit 53, n- type semiconductor layers 67, 69 are formed on the p- type semiconductor layer 63, and a voltage higher than that of the p-type semiconductor layer 63 is applied to the n- type semiconductor layers 67, 69, so that the depletion layer 70 is formed in the vicinity of the interface between the n- type semiconductor layers 67, 69 and the p-type semiconductor layer 63 to achieve electrical isolation.

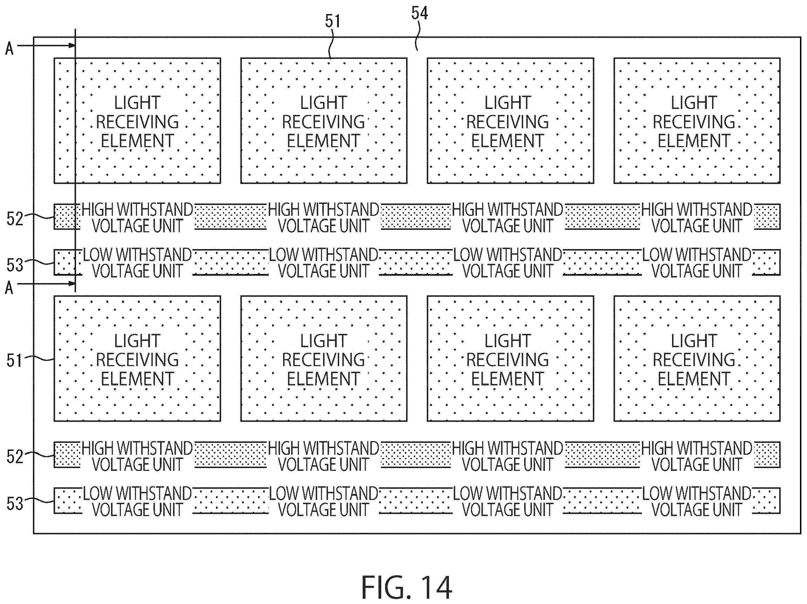

FIG. 14 is a plan view of the light detection device 1 of FIG. 13. A cross-sectional structure taken along line A-A in FIG. 14 is illustrated in FIGS. 12 and 13. As illustrated in FIG. 14, the individual light receiving element regions 51 are electrically isolated by the element isolation layer 54. A white void portion in FIG. 14 is the element isolation layer 54. Although the high withstand voltage unit 52 and the low withstand voltage unit 53 are provided for each light receiving element region 51, the plurality of high withstand voltage units 52 corresponding to the plurality of light receiving element regions 51 are continuously formed, and as similar to this, the plurality of low withstand voltage units 53 corresponding to the plurality of light receiving element regions 51 are continuously formed.

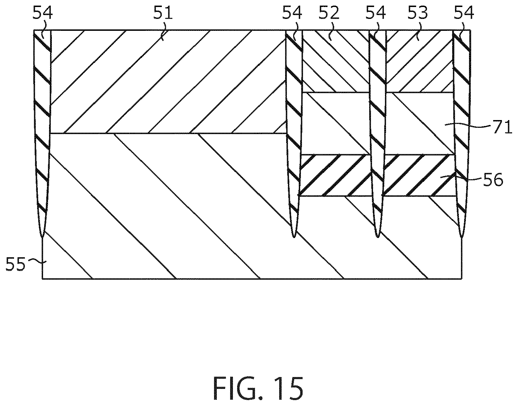

FIG. 15 is a cross-sectional view according to a first modification of FIG. 12. In FIG. 12, the depletion layer 70 is used as the protective layer 56, but in FIG. 15, for example, the protective layer 56 (also referred to as an insulating layer) made of an insulator is provided in the high withstand voltage unit 52 and the low withstand voltage unit 53. The protective layer 56 is arranged below the high withstand voltage unit 52 and the low withstand voltage unit 53 with, for example, the p-type semiconductor layer 71 interposed therebetween, and the base layer 55 is arranged below the protective layer 56. Even when the protective layer 56 made of an insulator is provided, the voltage of the base layer 55 can be prevented from being applied to the high withstand voltage unit 52 and the low withstand voltage unit 53. Note that, instead of the p-type semiconductor layer 71, an n-type semiconductor layer may be provided.

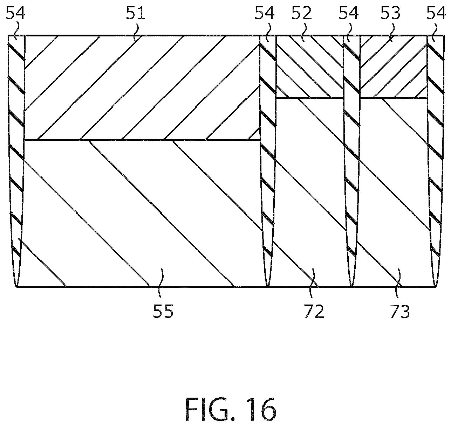

FIG. 16 is a cross-sectional view according to a second modification of FIG. 12. In the light detection device 1 of FIG. 16, the element isolation layer 54 between the light receiving element region 51 and the high withstand voltage unit 52 and the element isolation layer 54 between the high withstand voltage unit 52 and the low withstand voltage unit 53 penetrate from the upper surface to the lower surface of the substrate. As a result, the voltage applied to the base layer 55 arranged below the light receiving element region 51 is not applied to the high withstand voltage unit 52 and the p- type semiconductor layers 72, 73 in the low withstand voltage unit 53, and it is not always necessary to provide the protective layer 56 in the high withstand voltage unit 52 and the low withstand voltage unit 53.

In FIGS. 12 to 16, an example in which the light receiving element region 51, the high withstand voltage unit 52, and the low withstand voltage unit 53 constituting the light detection device 1 are arranged on the same substrate has been described, but members constituting the light detection device 1 may be divided into a plurality of substrates and arranged, and the plurality of substrates may be bonded together.

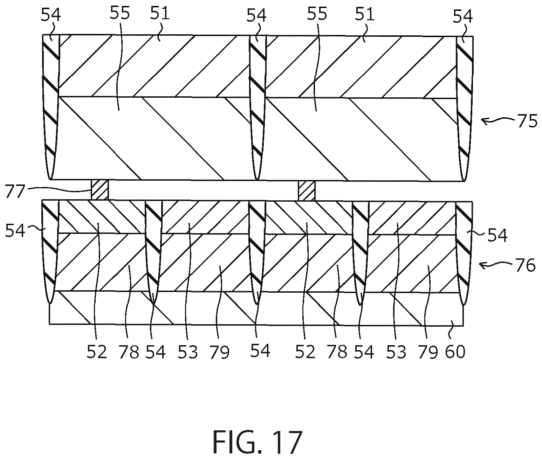

FIG. 17 is a cross-sectional view according to a third modification of FIG. 12. In the light detection device 1 of FIG. 17, a first substrate 75 on which the light receiving element region 51 is arranged and a second substrate 76 on which the high withstand voltage unit 52 and the low withstand voltage unit 53 are arranged are joined at a joint portion 77. The joint portion 77 is formed of a conductive material so that various signals can be transmitted and received between the first substrate 75 and the second substrate 76. The light receiving element region 51 and the base layer 55 are formed in the first substrate 75, and the high withstand voltage unit 52 and the low withstand voltage unit 53 are not formed. The element isolation layer 54 is arranged between the plurality of light receiving element regions 51 in the first substrate 75. On the second substrate 76, the high withstand voltage unit 52 and the low withstand voltage unit 53 are isolated by the element isolation layer 54 and alternately formed. The semiconductor layer 78 is arranged below the high withstand voltage unit 52, and the semiconductor layer 79 is arranged below the low withstand voltage unit 53. A common semiconductor layer 60 is arranged below the semiconductor layers 78 and 79. The conductivity type of the semiconductor layers 78, 79, 60 is not limited.

Since the light receiving element region 51 does not exist in the second substrate 76, the protective layer 56 in FIG. 12 and the like is unnecessary. As illustrated in FIG. 16, it is not necessary to cause the element isolation layer 54 to penetrate from the upper surface to the lower surface.

Although FIG. 17 illustrates an example in which the first substrate 75 and the second substrate 76 are bonded together, three or more substrates may be bonded together. For example, the first substrate 75 on which the light receiving element region 51 is arranged, the second substrate 76 on which the high withstand voltage unit 52 is arranged, and the third substrate on which the low withstand voltage unit 53 is arranged may be bonded together.

As described above, in the fourth example, since the element isolation layer 54 is arranged between the light receiving element region 51, the high withstand voltage unit 52, and the low withstand voltage unit 53 for electrical isolation, the light receiving element region 51, the high withstand voltage unit 52, and the low withstand voltage unit 53 can be arranged on the same substrate. The high withstand voltage unit 52 and the low withstand voltage unit 53 are arranged on a substrate different from the substrate on which the light receiving element region 51 is arranged, and these substrates are bonded together, and thereby, the highly reliable light detection device 1 can be achieved. In any structure, the light detection device 1 can be integrated into one chip.

(Specific example of electronic device 2)

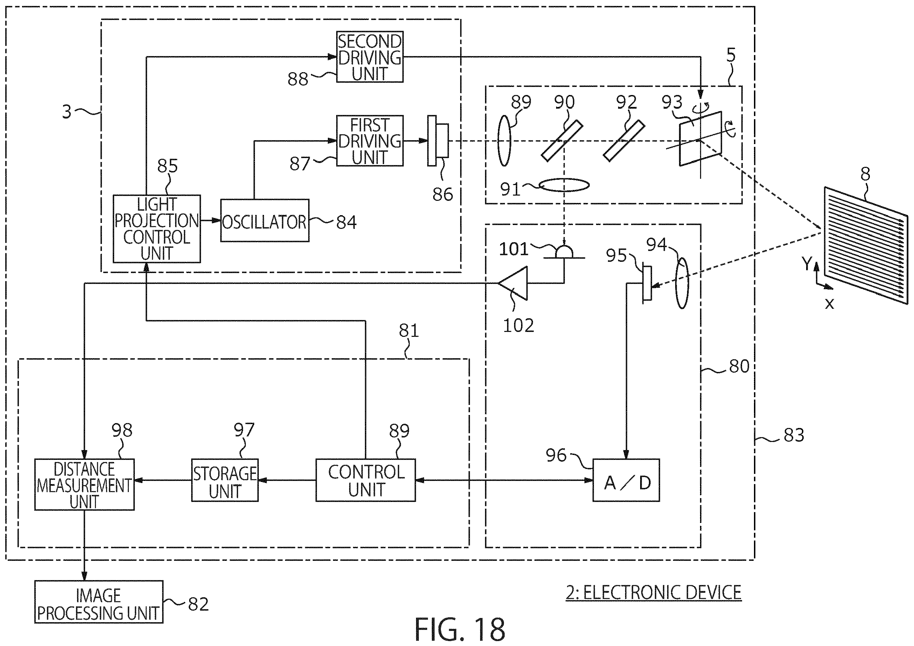

The light detection device 1 according to the present example can be incorporated in the electronic device 2 that performs distance measurement by a time of flight (ToF) method. FIG. 18 is a block diagram illustrating a schematic configuration of the electronic device 2 including a light receiving unit 80 incorporating the light detection device 1 according to the present example. The electronic device 2 of FIG. 18 includes the light projection unit 3, the light control unit 5, the light receiving unit 80, a signal processing unit 81, and an image processing unit 82. Among them, the light projection unit 3, the light control unit 5, the light receiving unit 80, and the signal processing unit 81 constitute a distance measuring device 83. At least a part of the electronic device 2 in FIG. 1 can be configured by one or a plurality of semiconductor integrated circuits (ICs). For example, the signal processing unit 81 and the image processing unit 82 may be integrated inside one semiconductor chip, or may be integrated in the semiconductor chip including the light receiving unit 80. The light projection unit 3 may also be integrated on the semiconductor chip.

The light projection unit 3 projects first light. The first light is, for example, laser light in a predetermined frequency band. The laser light is coherent light having a uniform phase and frequency. The light projection unit 3 intermittently projects the pulsed first light at a predetermined cycle. The cycle in which the light projection unit 3 projects the first light is a time interval equal to or longer than the time required for the distance measuring device 83 to measure the distance based on one pulse of the first light.

The light projection unit 3 includes an oscillator 84, a light projection control unit 85, a light source 86, a first driving unit 87, and a second driving unit 88. The oscillator 84 generates an oscillation signal corresponding to the cycle of projecting the first light. The first driving unit 87 intermittently supplies power to the light source 86 in synchronization with the oscillation signal. The light source 86 intermittently emits the first light based on the power from the first driving unit 87. The light source 86 may be a laser element that emits a single beam of laser light or a laser unit that simultaneously emits a plurality of beams of laser light. The light projection control unit 85 controls the second driving unit 88 in synchronization with the oscillation signal. The second driving unit 88 supplies a drive signal synchronized with the oscillation signal to the light control unit 5 in response to an instruction from the light projection control unit 85.

The light control unit 5 controls the traveling direction of the first light emitted from the light source 86. The light control unit 5 includes a first lens 89, a beam splitter 90, a second lens 91, a half mirror 92, and a scanning mirror 93.

The first lens 89 condenses the first light emitted from the light projection unit 3 and guides the first light to the beam splitter 90. The beam splitter 90 splits the first light from the first lens 89 in two directions and guides the first light to the second lens 91 and the half mirror 92. The second lens 91 guides the split light from the beam splitter 90 to the light receiving unit 80. The reason why the first light is guided to the light receiving unit 80 is that the light receiving unit 80 detects the light projection timing. The half mirror 92 passes the split light from the beam splitter 90 and guides the split light to the scanning mirror 93.

The scanning mirror 93 rotationally drives the mirror surface in synchronization with the drive signal from the second driving unit 88 in the light projection unit 3. As a result, the reflection direction of the split light (first light) that has passed through the half mirror 92 and entered the mirror surface of the scanning mirror 93 is controlled. By rotationally driving the mirror surface of the half mirror 92 at a constant cycle, the first light emitted from the light control unit 5 can be scanned in at least a one-dimensional direction. By providing the axes for rotationally driving the mirror surface in two directions, the first light emitted from the light control unit 5 can be scanned in a two-dimensional direction. FIG. 1 illustrates an example in which the scanning mirror 93 scans the first light projected from the electronic device 2 in the X direction and the Y direction.

When the target 8 such as a human or an object is present within the scanning range of the first light projected from the electronic device 2, the first light is reflected by the target 8. At least part of the reflected light reflected by the target 8 is guided to a light receiving sensor 95 through a third lens 94 in the light receiving unit 80.

The light receiving unit 80 includes a light detector 101, an amplifier 102, the third lens 94, the light receiving sensor 95, and an A/D converter 96. The light detector 101 receives light split by the beam splitter 90 and converts the light into an electric signal. The light detector 101 can detect the projection timing of the first light. The amplifier 102 amplifies the electric signal output from the light detector 101.

The third lens 94 forms an image of the second light reflected by the half mirror 92 on the light receiving sensor 95. The light receiving sensor 95 receives the second light and converts the second light into an electric signal. The light receiving sensor 95 includes the light detection device 1 described above. The light detection device 1 is also called a silicon photomultiplier (SiPM).

The A/D converter 96 samples the electric signal output from the light receiving sensor 95 at a predetermined sampling rate, performs A/D conversion, and generates a digital signal.

The signal processing unit 81 measures the distance to the target 8 that has reflected the first light, and stores a digital signal corresponding to the second light in the storage unit 97. The signal processing unit 81 includes a storage unit 97, a distance measurement unit 98, and a storage control unit 99.

The distance measurement unit 98 measures the distance to the target 8 based on the first light and the reflected light. More specifically, the distance measurement unit 98 measures the distance to the target based on the time difference between the light projection timing of the first light and the light reception timing of the reflected light included in the second light received by the light receiving sensor 95. That is, the distance measurement unit 98 measures the distance based on the following Formula (1).

$$\text{Distance} = \text{light speed} \times (\text{light reception timing of reflected light-light projection timing of first light})/2 \quad \dots (1)$$

The "light reception timing of the reflected light" in Expression (1) is more accurately the light reception timing of the peak position of the reflected light. The distance measurement unit 98 detects the peak position of the reflected light included in the second light based on the digital signal generated by the A/D converter 96.

By using the electronic device 2 illustrated in FIG. 18, the distance to the target 8 can be accurately measured. The electronic device 2 illustrated in FIG. 18 can be mounted on a vehicle and used for an automatic driving technique. Alternatively, the electronic device 2 illustrated in FIG. 18 is mounted on a portable device such as a smartphone or a tablet, and can be applied to three-dimensional image display, and virtual reality (VR), augmented reality (AR), and mixed reality (MR) technologies.

While certain examples have been described, these examples have been presented by way of example only, and are not intended to limit the scope of the disclosures. Indeed, the novel methods and systems described herein may be embodied in a variety of other forms; furthermore, various omissions, substitutions and changes in the form of the methods and systems described herein may be made without departing from the spirit of the disclosures. The accompanying claims and their equivalents are intended to cover such forms or modifications as would fall within the scope and spirit of the disclosures.

**Claims**

1. A light detection device comprising:

   a light receiving element that photoelectrically converts incident light; and
   a plurality of transistors that controls a bias voltage applied to the light receiving element and controlling reading of an output signal of the light receiving element,
   wherein the plurality of transistors comprise at least one or more transistors having a first withstand voltage and one or more transistors having a second withstand voltage higher than the first withstand voltage.

2. The light detection device according to claim 1, further comprising:

   a bias control circuit that switches between application of a first bias voltage to the light receiving element and application of a second bias voltage lower than the first bias voltage to the light receiving element; and
   an output circuit that amplifies an output signal of the light receiving element in a state where the first bias voltage is applied to the light receiving element,
   wherein the bias control circuit comprises a transistor having a withstand voltage higher than a withstand voltage of a transistor in the output circuit.

3. The light detection device according to claim 2,

   wherein the first bias voltage is a voltage higher than a breakdown voltage at which the light receiving element absorbs light by light irradiation to start generating a photoelectric conversion current, and
   the second bias voltage is lower than the breakdown voltage.

4. The light detection device according to claim 2 or 3,

   wherein the bias control circuit comprises:

      a first switching circuit that switches whether to apply the first bias voltage to one end of the light receiving element; and
      a second switching circuit that switches whether to apply the second bias voltage to the one end of the light receiving element,

   the output circuit comprises an amplifier that amplifies an output signal of the light receiving element in a state where the first bias voltage is applied to the one end of the light receiving element, and
   the first switching circuit and the second switching circuit each comprise a transistor having a withstand voltage higher than a withstand voltage of a transistor in the amplifier.

5.  The light detection device according to claim 4,
    wherein the amplifier converts an output current of the light receiving element into a voltage and outputs the voltage or outputs a current according to the output current of the light receiving element with reference to the first bias voltage.

6.  The light detection device according to claim 4 or 5,

    wherein the first switching circuit comprises a first transistor that switches whether to supply the output signal of the light receiving element to the amplifier in a state where the first bias voltage is applied to the one end of the light receiving element,
    the second switching circuit comprises:

    a second transistor that switches whether to apply the second bias voltage to the one end of the light receiving element; and
    a third transistor that controls a gate voltage of the second transistor, and

    the first to third transistors have a withstand voltage higher than the withstand voltage of the transistor in the amplifier.

7.  The light detection device according to claim 6,

    wherein the second switching circuit comprises a level shifter comprising the third transistor, and
    the level shifter controls the gate voltage of the second transistor with a signal amplitude larger than a signal amplitude input to a gate of the third transistor.

8.  The light detection device according to claim 4 or 5,

    wherein the first switching circuit comprises a first transistor that switches whether to supply the output signal of the light receiving element to the amplifier in a state where the first bias voltage is applied to one end of the light receiving element,
    the second switching circuit comprises a rectifier circuit that applies the second bias voltage to the one end of the light receiving element when the first transistor is turned off and the first bias voltage is not applied to the one end of the light receiving element, and
    the first transistor and a transistor in the rectifier circuit have a withstand voltage higher than the withstand voltage of the transistor in the amplifier.

9.  The light detection device according to claim 4 or 5, further comprising

    a light receiving cell array comprising a plurality of the light receiving element arranged in a first direction and a second direction on a two-dimensional plane,
    wherein the first switching circuit comprises a first transistor and a second transistor cascode-connected between the one end of the light receiving element and an input node of the amplifier,
    the second switching circuit comprises a third transistor and a fourth transistor that switch whether to apply the second bias voltage to the one end of the light receiving element,
    the first transistor and the third transistor are turned on when a light receiving element group at a specific position in the first direction where the light receiving element of a light detection target is located is selected, and
    the second transistor and the fourth transistor are turned on when a light receiving element group at a specific position in the second direction where the light receiving element of the light detection target is located is selected.

10. The light detection device according to claim 4 or 5, further comprising:

    a resistance element connected in series to the first switching circuit between the one end of the light receiving element and a reference voltage node;
    a quenching control circuit that performs control to initialize a voltage of the one end of the light receiving element based on an output signal of the amplifier; and
    a level shifter that converts a signal level of an output signal of the quenching control circuit,
    wherein the first switching circuit is subjected to switching control based on an output signal of the level shifter, and

the transistor in the quenching control circuit has a withstand voltage lower than a withstand voltage of the transistor in the first switching circuit.

**11.** The light detection device according to any one of claim 4-10,

wherein the amplifier comprises:

a first amplifier that amplifies the output signal of the light receiving element; and
a second amplifier that amplifies an output signal of the first amplifier,

a transistor in the first amplifier has a withstand voltage higher than a withstand voltage of a transistor in the second amplifier, and
the second amplifier has higher driving capability than driving capability of the first amplifier.

**12.** The light detection device according to claim 11,
wherein the first amplifier outputs a current or a voltage according to the output signal of the light receiving element.

**13.** The light detection device according to claim 11 or 12, further comprising

a light receiving cell array comprising a plurality of light receiving cells arranged in a first direction and a second direction on a two-dimensional plane,
the first amplifier in the output circuit is provided for each of the plurality of light receiving cells, and
the second amplifier in the output circuit is provided in a ratio of one for two or more of the light receiving cells.

**14.** An electronic device comprising:

the light detection device according to any one of claims 1-13; and
a measurer that measures a distance to an object based on a time difference between a light projection timing and a light reception timing in the light receiving element in an on state.

**15.** The electronic device according to claim 14, further comprising:

a light projector that projects light; and
a controller that controls the light receiving element, which is likely to receive light obtained by reflecting light projected from the light projector by an object, to be in the on state.

EP 4 040 187 A1

FIG. 1

FIG. 2A

FIG. 2B

FIG. 3

CL1

V₁

Q3~

CL2

Q1(21)~

V₁

Q2(22)~

~25

16

V₂

## FIG. 4A

CL1

Q1(21)~

Q2(22)~

16

V₂

## FIG. 4B

FIG. 4C

INPUT CURRENT $I_{in}$ →

OUTPUT VOLTAGE $V_{out}$

27

26

$V_1$

23

## FIG. 5A

**Vdd**

**1:n**

29

30

28

OUTPUT CURRENT $I_{out}$

INPUT CURRENT $I_{in}$

$V_1$

$\mathbf{I_{out} = I_{in} \times n}$

23

## FIG. 5B

FIG. 6

EP 4 040 187 A1

31

$V_x$

34

33

32

## FIG. 7A

31

35

33

32

## FIG. 7B

FIG. 7C

FIG. 7D

FIG. 8

FIG. 9

EP 4 040 187 A1

## 2D LIGHT RECEIVING CELL ARRAY

**1: LIGHT DETECTION DEVICE**

## FIG. 10

EP 4 040 187 A1

1: LIGHT DETECTION DEVICE

FIG. 11

54       51       54 52 67 54 69 53 54

56(70)

55

FIG. 12

FIG. 13

FIG. 14

FIG. 15

FIG. 16

FIG. 17

FIG. 18

2: ELECTRONIC DEVICE

Europäisches
Patentamt

European
Patent Office

Office européen
des brevets

# EUROPEAN SEARCH REPORT

**Application Number**

**EP 21 19 3869**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ACCONCIA GIULIA ET AL: "37ps-Precision Time-Resolving Active Quenching Circuit for High-Performance Single Photon Avalanche Diodes", IEEE PHOTONICS JOURNAL, IEEE, USA, vol. 10, no. 6, 1 December 2018 (2018-12-01), pages 1-13, XP011699881, DOI: 10.1109/JPHOT.2018.2884258 [retrieved on 2018-12-12] * chapter 1-3; figure 1 * | 1-15 | INV. G01S7/4863 G01S7/4914 H01L31/02 |
| X | DERVIC ALIJA ET AL: "Quadruple voltage mixed quenching and active resetting circuit in 150 nm CMOS for an external SPAD", 2020 23RD INTERNATIONAL SYMPOSIUM ON DESIGN AND DIAGNOSTICS OF ELECTRONIC CIRCUITS & SYSTEMS (DDECS), IEEE, 22 April 2020 (2020-04-22), pages 1-5, XP033772876, DOI: 10.1109/DDECS50862.2020.9095565 [retrieved on 2020-05-18] * figures 1,2,6 * | 1-15 | |
| | | | **TECHNICAL FIELDS SEARCHED (IPC)** |
| | | | G01S H01L |
| X | ACCONCIA G ET AL: "Fast fully integrated active quenching circuit for single photon counting up to 160 Mcounts/s", SPIE PROCEEDINGS; [PROCEEDINGS OF SPIE ISSN 0277-786X], SPIE, US, vol. 10978, 13 May 2019 (2019-05-13), pages 109780D-109780D, XP060121176, DOI: 10.1117/12.2518883 ISBN: 978-1-5106-3673-6 * paragraph [0002]; figure 1 * | 1-15 | |

-/--

The present search report has been drawn up for all claims

| Place of search | Date of completion of the search | Examiner |
|---|---|---|
| Munich | 2 February 2022 | Damp, Stephan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**page 1 of 2**

Europäisches
Patentamt

European
Patent Office

Office européen
des brevets

## EUROPEAN SEARCH REPORT

**Application Number**

EP 21 19 3869

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DERVIC ALIJA ET AL: "High-voltage active quenching and resetting circuit for SPADs in 0.35 [mu]m CMOS for raising the photon detection probability", OPTICAL ENGINEERING, SOC. OF PHOTO-OPTICAL INSTRUMENTATION ENGINEERS, BELLINGHAM, vol. 58, no. 4, 1 April 2019 (2019-04-01), page 40501, XP060138547, ISSN: 0091-3286, DOI: 10.1117/1.OE.58.4.040501 [retrieved on 2019-04-10] * figure 1 * ----- | 1-15 | |

| | TECHNICAL FIELDS SEARCHED (IPC) |
|---|---|

The present search report has been drawn up for all claims

| Place of search | Date of completion of the search | Examiner |
|---|---|---|
| Munich | 2 February 2022 | Damp, Stephan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**page 2 of 2**